**Europäisches Patentamt**

**European Patent Office**

**Office européen des brevets**

(19)

(11) **EP 1 331 674 A1**

(12) **DEMANDE DE BREVET EUROPEEN**

(43) Date de publication:
**30.07.2003 Bulletin 2003/31**

(51) Int Cl.⁷: $H01L\ 35/32$, $H01L\ 35/34$

(21) Numéro de dépôt: **02405040.3**

(22) Date de dépôt: **24.01.2002**

(84) Etats contractants désignés:
**AT BE CH CY DE DK ES FI FR GB GR IE IT LI LU MC NL PT SE TR**
Etats d'extension désignés:
**AL LT LV MK RO SI**

(71) Demandeur: **PX Tech S.A.**
**2304 La Chaux-de-Fonds (CH)**

(72) Inventeur: **Keppner, Herbert**
**2013 Colombier (CH)**

(74) Mandataire: **Gresset, Jean**
**GLN**
**Gresset & Laesser Neuchâtel**
**Puits-Godet 8A**
**2000 Neuchâtel (CH)**

(54) **Convertisseur thermoélectrique miniature à haute intégration**

(57) L'invention concerne un convertisseur d'énergie thermoélectrique comportant:

- un substrat (10) formé d'une feuille de matériau isolant percée d'une pluralité de canaux (12) perpendiculaires à ses faces (16, 18),
- une pluralité d'éléments conducteurs d'un premier et d'un deuxième types (14a, 14b), disposés à l'intérieur desdits canaux en alternant éléments du premier type et éléments du deuxième type, et

- une pluralité de pistes conductrices (20, 22) disposées sur chaque face du substrat pour connecter en série lesdits éléments (14a, 14b), de manière à ce que chaque élément d'un type soit relié à deux éléments de l'autre type respectivement par une piste d'une des faces et par une piste de l'autre face, lesdites faces (16, 18) constituant les faces chaude et froide, respectivement, du convertisseur.

Fig.1

**Description**

La présente invention se rapporte aux convertisseurs d'énergie par effet thermoélectrique Seebeck ou Peltier.

On rappellera que, selon l'effet Seebeck, une différence de température entre les points de contact de deux conducteurs différents crée une différence de potentiel entre leurs extrémités ouvertes, alors que, selon l'effet Peltier, un courant circulant à travers le contact entre ces deux conducteurs provoque, selon le sens du courant, un échauffement ou un refroidissement du contact.

L'exploitation de l'effet Seebeck permet, lorsque plusieurs couples de conducteurs différents (couples thermoélectriques) sont mis en série et en mettant les contacts alternativement à température élevée (soudures chaudes) et à température basse (soudures froides), de réaliser un générateur thermoélectrique ou un senseur de température. L'exploitation de l'effet Peltier permet, à l'inverse, d'utiliser la même structure pour créer du froid.

L'invention concerne, plus précisément, un convertisseur d'énergie par effet thermoélectrique miniature à haute intégration ainsi que son procédé de fabrication.

Un tel convertisseur est particulièrement destiné à constituer un générateur thermoélectrique, appelé aussi thermopile, remplaçant la pile ou l'accumulateur qui assurent l'alimentation de microsystèmes ou de petits appareils, tels que les montres.

Des thermopiles miniatures ont déjà été proposées, par exemple, dans la publication "Thermopiles fabricated using silicon planar technology" de "Sensors and Actuators, 3 (1982/83) 179-83. La thermopile décrite dans cet article utilise, comme substrat, une mince feuille de silicium comportant, sur une face, un réseau de bandes de silicium de type p et, sur l'autre face, un réseau de bandes d'aluminium. Les bandes des deux réseaux sont interconnectées en série, à travers le substrat, de manière à alterner contacts chauds et contacts froids.

Une telle technique permet, certes, d'obtenir une pile de très petites dimensions mais elle a un inconvénient. En effet, puisque le flux thermique à convertir en électricité traverse la pile parallèlement au substrat, la surface de contact avec la source chaude est limitée à l'arête de la pile. La quantité d'énergie ainsi captée étant donc assez faible, la puissance délivrée est également faible.

La présente invention a pour but de fournir une structure de convertisseur d'énergie miniaturisé exempt de l'inconvénient sus-mentionné, utilisable notamment comme générateur thermoélectrique.

Pour atteindre ce but, le convertisseur d'énergie thermoélectrique selon l'invention comporte:

- un substrat formé d'une feuille de matériau isolant percée d'une pluralité de canaux perpendiculaires à ses faces,

- une pluralité d'éléments conducteurs d'un premier et d'un deuxième types, disposés à l'intérieur des canaux en alternant éléments du premier type et éléments du deuxième type, et

- une pluralité de pistes conductrices disposées sur chaque face du substrat pour connecter en série les éléments conducteurs de manière à ce que chaque élément d'un type soit relié à deux éléments de l'autre type respectivement par une piste d'une des faces et par une piste de l'autre face, ces deux faces constituant les faces chaude et froide, respectivement, du convertisseur.

Selon l'invention, le convertisseur d'énergie présente encore, de manière avantageuse, les principales caractéristiques suivantes:

- la feuille formant substrat est flexible et réalisée en polymère, de préférence, du polyimide;

- les éléments conducteurs sont en un matériau semi-conducteur respectivement de type p et de type n;

- le matériau est un tellurure de bismuth dopé;

- pour le semi-conducteur de type p, le dopant est l'antimoine alors que, pour le semi-conducteur de type n, le dopant est le selenium;

- le matériau semi-conducteur est sous la forme d'une poudre mélangée à une résine époxy polymérisée;

- les pistes conductrices sont en cuivre.

La présente invention concerne aussi un procédé de fabrication du convertisseur d'énergie décrit ci-dessus. Il consiste à se munir d'une feuille de matériau isolant revêtue, sur ses deux faces, d'une couche conductrice, puis à effectuer successivement les opérations de:

- gravure des deux couches conductrices pour y former des trous marquant les emplacements des futurs canaux,

- percement, à partir de l'une des faces, des canaux qui recevront les éléments conducteurs d'un type et, à partir de l'autre face, des canaux qui recevront les éléments conducteurs de l'autre type,

- remplissage des canaux à l'aide de mélanges de résine époxy et de poudre semi-conductrice respectivement de type p et de type n,

- dépôt sur les deux faces d'une nouvelle couche conductrice coiffant les extrémités des éléments conducteurs, et

- structuration des deux couches conductrices pour former les pistes conductrices.

D'autres caractéristiques et avantages de l'invention ressortiront de la description qui va suivre, faite en regard du dessin annexé, dans lequel:

- la figure 1 représente schématiquement le convertisseur d'énergie, avec un nombre limité d'éléments; et
- les figures 2 à 7 illustrent les principales étapes du procédé de fabrication d'un tel convertisseur.

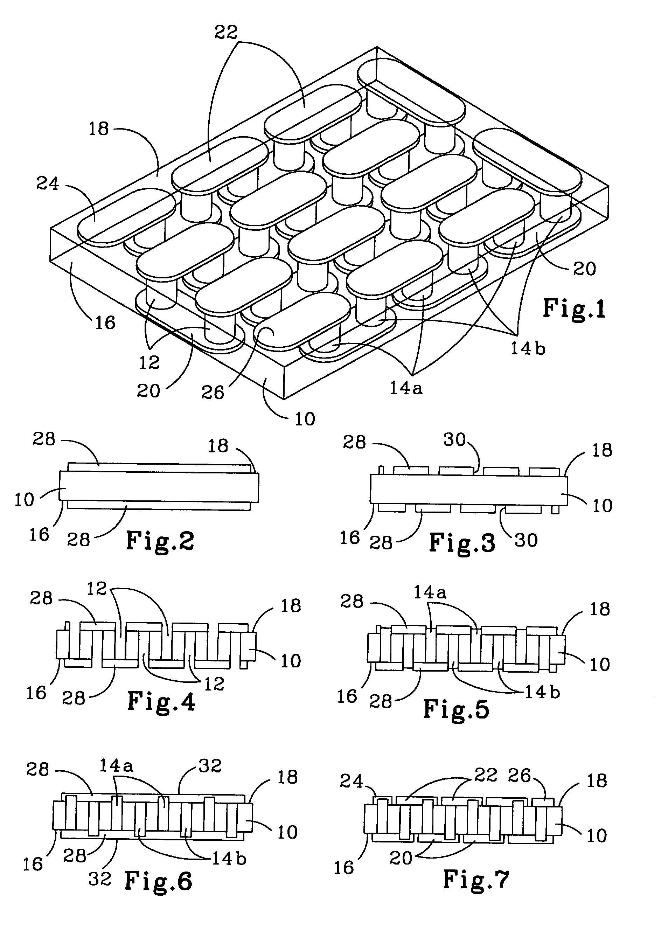

Sur la figure 1, on a représenté en 10 une mince feuille de polymère, avantageusement un polyimide, dont l'épaisseur est, typiquement de 80 $\mu$m. Cette feuille est percée d'une matrice de canaux cylindriques 12, d'axes perpendiculaires à ses faces et régulièrement espacés. Dans l'exemple décrit, les canaux ont un diamètre de 100 $\mu$m et sont espacés de 150 $\mu$m.

Selon l'invention, les canaux 12 contiennent chacun un élément conducteur 14 fait en un matériau présentant à la fois une bonne conductibilité électrique, une mauvaise conductibilité thermique et un coefficient Seebeck élevé. Puisqu'il s'agit de réaliser un convertisseur thermoélectrique, ces éléments sont réalisés en deux matériaux différents et disposés dans les canaux 12 en alternant les éléments d'un premier type 14a et les éléments d'un deuxième type 14b. Ainsi, deux éléments d'un type sont séparés par un élément de l'autre type.

De façon avantageuse, les matériaux utilisés pour constituer les éléments 14 sont sous la forme d'une poudre semi-conductrice diluée dans résine époxy polymérisée. Le semi-conducteur est de type p pour les électrodes 14a et de type n pour les électrodes 14b.

Selon une réalisation préférée, la poudre semi-conductrice utilisée est un tellurure de bismuth dopé qui présente un excellent rapport conductibilité électrique / conductibilité thermique et un coefficient Seebeck élevé. Par exemple, pour les électrodes 14a de type p, le dopant est l'antimoine et la poudre répond à la formule

$$(Bi_{0,75} Sb_{0,25})_2 Te_3,$$

alors que, pour les électrodes 14b de type n, le dopant est le selenium et la poudre répond à la formule

$$Bi_2 (Te_{0,90} Se_{0,10})_3.$$

Bien entendu, l'invention n'est pas limitée à ce mode de réalisation. Par exemple, le matériau des électrodes 14a, de type p, peut être la pyrite ($FeS_2$) et celui des électrodes 14b, de type n, peut être l'acier inox.

Afin de faciliter la suite de la description, on conviendra que la face inférieure 16 du convertisseur est la face chaude et que sa face supérieure 18 est la face froide. Comme le montre bien la figure 1, chaque électrode 14a est reliée, d'un côté, à l'électrode voisine 14b par une piste conductrice 20 disposée sur la face chaude 16 et, de l'autre côté, à son autre voisine 14b par une piste conductrice 22 disposée sur la face froide 18. De manière identique, et bien évidemment, chaque électrode 14b est reliée, d'un côté, à l'électrode voisine 14a par une piste 20 sur la face chaude 16 et, de l'autre côté, à son autre voisine 14a par une piste 22 sur la face froide.

De manière avantageuse, les pistes 20 et 22 sont en cuivre et ont, typiquement, une épaisseur de 10 $\mu$m.

On se référera maintenant aux figures 2 à 7 qui illustrent les principales étapes de fabrication d'un convertisseur d'énergie tel que précédemment décrit.

La première étape, schématisée à la figure 2, consiste à se munir de la mince feuille de polymère 10 et à revêtir ses deux faces 16 et 18 d'une couche conductrice 28, avantageusement constituée d'une feuille de cuivre déposée par laminage et ayant, typiquement, une épaisseur de 5 à 10 $\mu$m.

Lors de l'étape suivante, illustrée par la figure 3, les deux couches 28 sont gravées chimiquement pour y former des trous 30 marquant les emplacements des futurs canaux 12.

La troisième étape, représentée à la figure 4, consiste à percer les canaux 12 dans la feuille 10. Le percement s'effectue à partir de la face froide 18 pour les canaux qui recevront les électrodes 14a et à partir de la face chaude 16 pour les canaux qui recevront les électrodes 14b. De préférence, l'opération est réalisée par une technique connue sous la dénomination de Reactive Ion Etching (RIE), mais elle peut aussi se faire par tout autre procédé d'usinage, notamment par ablation laser sur grande surface.

Comme le montre la figure 5, les canaux 12, obturés à une extrémité par la couche 28, sont alors aisément remplis des mélanges pâteux de résine époxy et de poudre semi-conductrice mentionnés précédemment qui constitueront les éléments conducteurs 14a et 14b. Dans l'exemple décrit, les canaux destinés aux électrodes 14a reçoivent un mélange dans lequel la poudre semi-conductrice est de type p, alors que les canaux destinés aux électrodes 14b reçoivent un mélange dans lequel la poudre semi-conductice est de type n. La polymérisation de l'époxy permet alors de solidifier les électrodes 14a et 14b.

Lors de l'étape suivante, illustrée par la figure 6, les deux faces sont recouvertes d'une couche supplémentaire de cuivre 32, avantageusement déposée par PVD ou galvanisation, qui coiffe les extrémités des électrodes 14.

Il ne reste plus, alors, comme montré sur la figure 7, qu'à structurer les deux couches de cuivre, avantageusement par photolithographie ou sérigraphie, pour former les pistes de contact 20 et 22.

Ainsi est réalisé un convertisseur thermoélectrique dans lequel, à la différence des réalisations antérieures, le flux thermique traverse la structure perpendiculairement au substrat. De ce fait, la face chaude n'est pas l'arête du convertisseur mais la totalité de la surface des pistes 20. Il est donc possible de capter une quantité d'énergie beaucoup plus importante et produire ainsi d'avantage d'électricité. De plus, le mince substrat en polymère est très souple et s'adapte donc à la forme de la source de chaleur sur laquelle il est placé.

A titre indicatif, une thermopile comportant 3000 électrodes réparties sur une feuille souple de 2 x 2 cm, formant ainsi 2999 couples thermoélectriques, permet de délivrer, à ses bornes 24 et 26 qui constituent les deux extrémités du circuit, une puissance maximale de 10 µW pour une différence de température de l'ordre de 5°C.

Lorsqu'il est utilisé comme thermopile, en utilisant l'effet Seebeck, le convertisseur d'énergie qui vient d'être décrit, en même temps que son procédé de fabrication, trouve son utilité dans les systèmes autonomes à faible consommation placés dans un environnement offrant une différence de température. La montre constitue, certes, un domaine d'application idéal mais divers autres dispositifs, notamment à usage médical, peuvent bénéficier de ce type de thermopile.

Bien entendu, le convertisseur selon l'invention trouve d'autres applications basées sur l'effet Peltier pour réaliser, notamment, des thermomètres et des sources de froid.

## Revendications

1. Convertisseur d'énergie thermoélectrique, **caractérisé en ce qu'**il comporte:

   - un substrat (10) formé d'une feuille de matériau isolant percée d'une pluralité de canaux (12) perpendiculaires à ses faces (16, 18),
   - une pluralité d'éléments conducteurs d'un premier et d'un deuxième types (14a, 14b), disposés à l'intérieur desdits canaux en alternant éléments du premier type et éléments du deuxième type, et
   - une pluralité de pistes conductrices (20, 22) disposées sur chaque face du substrat pour connecter en série lesdits éléments (14a, 14b), de manière à ce que chaque élément d'un type soit relié à deux éléments de l'autre type respectivement par une piste d'une des faces et par une piste de l'autre face, lesdites faces (16, 18) constituant les faces chaude et froide, respectivement, du convertisseur.

2. Convertisseur selon la revendication 1, **caractérisé en ce que** ladite feuille (10) est flexible et réalisée en polymère.

3. Convertisseur selon la revendication 2, **caractérisé en ce que** ladite feuille (10) est en polyimide.

4. Convertisseur selon l'une des revendications 1 à 3, **caractérisé en ce que** lesdits éléments conducteurs (14a, 14b) sont en un matériau semi-conducteur respectivement de type p et de type n.

5. Convertisseur selon la revendication 4, caractérisé en que ledit matériau est un tellurure de bismuth dopé.

6. Convertisseur selon la revendication 5, **caractérisé en ce que**, pour le semi-conducteur de type p, le dopant est l'antimoine et, pour le semi-conducteur de type n, le dopant est le selenium.

7. Convertisseur selon l'une des revendications 4 à 6, **caractérisé en ce que** le matériau semi-conducteur est sous la forme d'une poudre mélangée à une résine époxy polymérisée.

8. Convertisseur selon l'une des revendications 1 à 7, **caractérisé en ce que** lesdites pistes (20, 22) sont en cuivre.

9. Procédé de fabrication du convertisseur d'énergie selon l'une des revendications 1 à 8, **caractérisé en ce qu'**il consiste à se munir d'une feuille de matériau isolant (10) revêtue, sur ses deux faces (16, 18), d'une couche conductrice (28), puis à effectuer successivement les opérations de:

   - gravure des deux couches conductrices (28) pour y former des trous (30) marquant les emplacements des futurs canaux (12),
   - percement, à partir de l'une des faces (16, 18), des canaux (12) qui recevront les éléments conducteurs (14a, 14b) d'un type et, à partir de l'autre face (16, 18), des canaux (12) qui recevront les éléments conducteurs de l'autre type (14a, 14b),
   - remplissage desdits canaux (12) à l'aide de mélanges de résine époxy et de poudre semi-conductrice respectivement de type p et de type n,
   - dépôt sur les deux faces (16, 18) d'une nouvelle couche conductrice (32) coiffant les extrémités des éléments conducteurs (14a, 14b), et
   - structuration des deux couches conductrices (28, 32) pour former lesdites pistes conductrices (20, 22).

Fig.1

Fig.2

Fig.3

Fig.4

Fig.5

Fig.6

Fig.7

Office européen
des brevets

## RAPPORT DE RECHERCHE EUROPEENNE

Numéro de la demande

EP 02 40 5040

### DOCUMENTS CONSIDERES COMME PERTINENTS

| Catégorie | Citation du document avec indication, en cas de besoin, des parties pertinentes | Revendication concernée | CLASSEMENT DE LA DEMANDE (Int.Cl.7) |
|---|---|---|---|
| X | WO 99 65086 A (MATIJASEVIC GORAN S ;BRANDT LUTZ (US); HA LINH (US); ORMET CORP (U) 16 décembre 1999 (1999-12-16) * le document en entier * | 1-9 | H01L35/32 H01L35/34 |
| X | PATENT ABSTRACTS OF JAPAN vol. 014, no. 365 (E-0961), 8 août 1990 (1990-08-08) & JP 02 130877 A (MATSUSHITA ELECTRIC IND CO LTD), 18 mai 1990 (1990-05-18) | 1-6,8 | |
| A | * abrégé; figure 2 * | 7,9 | |
| X | US 5 952 728 A (IMANISHI ET AL) 14 septembre 1999 (1999-09-14) | 1,4,8 | |
| A | * colonne 5, ligne 28 - colonne 8, ligne 35; figures 3,4A-4E,,5A-5C * | 2,3,5-7,9 | |

DOMAINES TECHNIQUES RECHERCHES (Int.Cl.7)

H01L

Le présent rapport a été établi pour toutes les revendications

| Lieu de la recherche | Date d'achèvement de la recherche | Examinateur |
|---|---|---|
| LA HAYE | 1 août 2002 | Kirkwood, J |

EPO FORM 1503 03.82 (P04C02)

**ANNEXE AU RAPPORT DE RECHERCHE EUROPEENNE
RELATIF A LA DEMANDE DE BREVET EUROPEEN NO.**　　　　EP 02 40 5040

La présente annexe indique les membres de la famille de brevets relatifs aux documents brevets cités dans le rapport de recherche européenne visé ci-dessus.
Lesdits members sont contenus au fichier informatique de l'Office européen des brevets à la date du
Les renseignements fournis sont donnés à titre indicatif et n'engagent pas la responsabilité de l'Office européen des brevets.

01-08-2002

| Document brevet cité au rapport de recherche | | | Date de publication | Membre(s) de la famille de brevet(s) | | | Date de publication |
|---|---|---|---|---|---|---|---|
| WO 9965086 | A | | 16-12-1999 | US | 6127619 | A | 03-10-2000 |
| | | | | AU | 4551399 | A | 30-12-1999 |
| | | | | WO | 9965086 | A1 | 16-12-1999 |
| JP 02130877 | A | | 18-05-1990 | AUCUN | | | |
| US 5952728 | A | | 14-09-1999 | JP | 9199765 | A | 31-07-1997 |
| | | | | DE | 19646905 | A1 | 15-05-1997 |
| | | | | DE | 19646915 | A1 | 15-05-1997 |
| | | | | FR | 2741197 | A1 | 16-05-1997 |
| | | | | FR | 2741196 | A1 | 16-05-1997 |
| | | | | GB | 2307338 | A ,B | 21-05-1997 |
| | | | | GB | 2307339 | A ,B | 21-05-1997 |
| | | | | JP | 9199766 | A | 31-07-1997 |
| | | | | US | 6306673 | B1 | 23-10-2001 |
| | | | | US | 5705434 | A | 06-01-1998 |

EPO FORM P0460